(19) Europäisches Patentamt
European Patent Office
Office européen des brevets

(11) **EP 2 727 140 B1**

(12) **EUROPEAN PATENT SPECIFICATION**

(45) Date of publication and mention
of the grant of the patent:
**27.03.2019   Bulletin 2019/13**

(21) Application number: **12823181.8**

(22) Date of filing: **28.06.2012**

(51) Int Cl.:
*H01L 21/78* (2006.01)      *H01L 31/18* (2006.01)

(86) International application number:
**PCT/US2012/044620**

(87) International publication number:
**WO 2013/095712 (27.06.2013 Gazette 2013/26)**

(54) **SACRIFICIAL ETCH PROTECTION LAYERS FOR REUSE OF WAFERS AFTER EPITAXIAL LIFT OFF**

ÄTZSCHUTZOPFERSCHICHTEN ZUR WIEDERVERWENDUNG VON WAFERN NACH DER EPITAXIALSCHICHTANHEBUNG

COUCHES DE PROTECTION DE GRAVURE SACRIFICIELLE POUR RÉUTILISATION DE TRANCHES APRÈS ARRACHAGE ÉPITAXIAL

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.06.2011   US 201161502401 P**

(43) Date of publication of application:
**07.05.2014   Bulletin 2014/19**

(73) Proprietor: **The Regents Of The University Of Michigan**
**Ann Arbor, Michigan 48109 (US)**

(72) Inventors:
• **The inventors have waived their right to be thus mentioned.**

(74) Representative: **Finnegan Europe LLP**
**1 London Bridge**
**London SE1 9BG (GB)**

(56) References cited:
**EP-A2- 1 635 383      DE-A1-102008 034 801**

• **VAN GEELEN A ET AL: "Epitaxial lift-off GaAs solar cell from a reusable GaAs substrate", MATERIALS SCIENCE AND ENGINEERING B, ELSEVIER SEQUOIA, LAUSANNE, CH, vol. 45, no. 1-3, 1 March 1997 (1997-03-01), pages 162-171, XP004083654, ISSN: 0921-5107, DOI: 10.1016/S0921-5107(96)02029-6**

**Description**

The present disclosure generally relates to methods of making electronic and optoelectronic devices, such as flexible photovoltaic devices, through the use of epitaxial liftoff. In particular, the disclosure relates to methods for preparing flexible photovoltaic devices through epitaxial growth and preserving the integrity of growth substrates for reuse.

Optoelectronic devices rely on the optical and electronic properties of materials to either produce or detect electromagnetic radiation electronically or to generate electricity from ambient electromagnetic radiation.

Photosensitive optoelectronic devices convert electromagnetic radiation into electricity. Solar cells, also called photovoltaic (PV) devices, are a type of photosensitive optoelectronic device that is specifically used to generate electrical power. PV devices, which may generate electrical energy from light sources other than sunlight, can be used to drive power consuming loads to provide, for example, lighting, heating, or to power electronic circuitry or devices such as calculators, radios, computers or remote monitoring or communications equipment. These power generation applications also often involve the charging of batteries or other energy storage devices so that operation may continue when direct illumination from the sun or other light sources is not available, or to balance the power output of the PV device with a specific application's requirements. As used herein the term "resistive load" refers to any power consuming or storing circuit, device, equipment or system.

Another type of photosensitive optoelectronic device is a photoconductor cell. In this function, signal detection circuitry monitors the resistance of the device to detect changes due to the absorption of light.

Another type of photosensitive optoelectronic device is a photodetector. In operation, a photodetector is used in conjunction with a current detecting circuit which measures the current generated when the photodetector is exposed to electromagnetic radiation and may have an applied bias voltage. A detecting circuit as described herein is capable of providing a bias voltage to a photodetector and measuring the electronic response of the photodetector to electromagnetic radiation.

These three classes of photosensitive optoelectronic devices may be characterized according to whether a rectifying junction as defined below is present and also according to whether the device is operated with an external applied voltage, also known as a bias or bias voltage. A photoconductor cell does not have a rectifying junction and is normally operated with a bias. A PV device has at least one rectifying junction and is operated with no bias. A photodetector has at least one rectifying junction and is usually but not always operated with a bias. As a general rule, a photovoltaic cell provides power to a circuit, device or equipment, but does not provide a signal or current to control detection circuitry, or the output of information from the detection circuitry. In contrast, a photodetector or photoconductor provides a signal or current to control detection circuitry, or the output of information from the detection circuitry but does not provide power to the circuitry, device or equipment.

Traditionally, photosensitive optoelectronic devices have been constructed of a number of inorganic semiconductors, e.g., crystalline, polycrystalline and amorphous silicon, gallium arsenide, cadmium telluride and others. Herein the term "semiconductor" denotes materials which can conduct electricity when charge carriers are induced by thermal or electromagnetic excitation. The term "photoconductive" generally relates to the process in which electromagnetic radiant energy is absorbed and thereby converted to excitation energy of electric charge carriers so that the carriers can conduct, *i.e.,* transport, electric charge in a material. The terms "photoconductor" and "photoconductive material" are used herein to refer to semiconductor materials which are chosen for their property of absorbing electromagnetic radiation to generate electric charge carriers.

PV devices may be characterized by the efficiency with which they can convert incident solar power to useful electric power. Devices utilizing crystalline or amorphous silicon dominate commercial applications, and some have achieved efficiencies of 23% or greater. However, efficient crystalline-based devices, especially of large surface area, are difficult and expensive to produce due to the problems inherent in producing large crystals without significant efficiency-degrading defects. On the other hand, high efficiency amorphous silicon devices still suffer from problems with stability. Present commercially available amorphous silicon cells have stabilized efficiencies between 4 and 8%.

PV devices may be optimized for maximum electrical power generation under standard illumination conditions (i.e., Standard Test Conditions which are 1000 W/m$^2$, AM1.5 spectral illumination), for the maximum product of photocurrent times photovoltage. The power conversion efficiency of such a cell under standard illumination conditions depends on the following three parameters: (1) the current under zero bias, i.e., the short-circuit current $I_{SC}$, in Amperes (2) the photovoltage under open circuit conditions, i.e., the open circuit voltage $V_{OC}$, in Volts and (3) the fill factor, *FF.*

PV devices produce a photo-generated current when they are connected across a load and are irradiated by light. When irradiated under infinite load, a PV device generates its maximum possible voltage, V open-circuit, or $V_{OC}$. When irradiated with its electrical contacts shorted, a PV device generates its maximum possible current, I short-circuit, or $I_{SC}$. When actually used to generate power, a PV device is connected to a finite resistive load and the power output is given by the product of the current and voltage, $I \times V$. The maximum total power generated by a PV device is inherently incapable of exceeding the product, $I_{SC} \times V_{OC}$. When the load value is optimized for maximum power extraction, the current and voltage have the values, $I_{max}$ and $V_{max}$, respectively.

A figure of merit for PV devices is the fill factor, *FF*, defined as:

$$FF = \{\, I_{max}\, V_{max}\,\}/\{\, I_{SC}\, V_{OC}\,\} \qquad\qquad (1)$$

where FF is always less than 1, as $I_{SC}$ and $V_{OC}$ are never obtained simultaneously in actual use. Nonetheless, as *FF* approaches 1, the device has less series or internal resistance and thus delivers a greater percentage of the product of $I_{SC}$ and $V_{OC}$ to the load under optimal conditions. Where $P_{inc}$ is the power incident on a device, the power efficiency of the device, $\eta_P$, may be calculated by:

$$\eta_P = FF^* \, (I_{SC} * V_{OC}) / P_{inc}$$

To produce internally generated electric fields that occupy a substantial volume of the semiconductor, the usual method is to juxtapose two layers of material with appropriately selected conductive properties, especially with respect to their distribution of molecular quantum energy states. The interface of these two materials is called a photovoltaic junction. In traditional semiconductor theory, materials for forming PV junctions can be fabricated so that they are either n- or p-type. Here n-type denotes that the majority carrier type is the electron. This could be viewed as the material having many electrons in relatively free energy states. Here p-type denotes that the majority carrier type is the hole. Such material has many holes in relatively free energy states. The type of the background, i.e., not photo-generated, majority carrier concentration depends primarily on doping by defects or impurities, either intentional or unintentional. The type and concentration of impurities determine the value of the Fermi energy, or level, within the gap between the conduction band minimum and valance band maximum energies. The Fermi energy characterizes the statistical occupation of molecular quantum energy states denoted by the value of energy for which the probability of occupation is equal to ½. A Fermi energy near the conduction band minimum energy indicates that electrons are the predominant carrier. A Fermi energy near the valence band maximum energy indicates that holes are the predominant carrier. Accordingly, the Fermi energy is a primary characterizing property of traditional semiconductors and the prototypical PV structure has traditionally been the p-n junction.

The term "rectifying" denotes, *inter alia,* that an interface has an asymmetric conduction characteristic, i.e., the interface supports electronic charge transport preferably in one direction. Rectification is associated normally with a built-in electric field which occurs at the junction between appropriately selected materials.

Conventional inorganic semiconductor PV cells employ a p-n junction to establish an internal field. High-efficiency PV devices are typically produced on expensive, single crystal growth substrates. These growth substrates may include single crystal wafers, which can be used for creating a perfect lattice and structural support for the epitaxial growth of active layers, also known as "epilayers." These epilayers may be integrated into PV devices with their original growth substrates intact. Alternatively, those epilayers may be removed and recombined with a host substrate.

In some instances, it may be desirable to transfer the epilayers to host substrates that exhibit desirable optical, mechanical, or thermal properties. For example, Gallium Arsenide (GaAs) epilayers may be grown on Silicon (Si) substrates. However, the electronic quality of the resulting material may be insufficient for certain electronic applications. Therefore, it may be desirable to preserve the high material quality of the lattice-matched epilayers, while allowing the integration of those epilayers into other substrates. This may be accomplished by a method known as epitaxial liftoff. In epitaxial liftoff processes, epilayers may be "lifted off" growth layers and recombined (*e.g.*, bonded or adhered) to a new host substrate.

Although they may provide desirable epitaxial growth characteristics, typical growth substrates can be thick and create excess weight, and the resulting devices tend to be fragile and require bulky support systems. Epitaxial liftoff may be a desirable way to transfer epilayers from their growth substrates to more efficient, light-weight, and flexible host substrates. Given the relative scarcity of typical growth substrates and the desirable characteristics that they impart on resulting cell structures, it may be desirable to recycle and/or reuse growth substrates in subsequent epitaxial growths. However, prior attempts to reuse growth wafers have either resulted in reduced efficiency or required abrasive "polishing" of the wafer by removing the top several micrometers of material from the wafer.

U.S. Patent Publication No. 2010/0047959 describes a method for selectively freeing an epitaxial layer from a single crystal substrate. The described method includes the deposition of a first buffer layer, an etch stop layer, a second buffer layer, and a separation layer. Above the separation layer, a sequence of semiconductor layers is deposited to form a cell. The method then comprises etching the separation layer, whereby semiconductor layers are pulled away from the substrate and the associated buffer layers and etch stop layer. However, the specification does not describe a method of preparing the liberated substrate for reuse, such as, for example, selectively etching away the buffer layers and/or etch stop layers.

DE 10 2008 034801 A1 (CHEN HUNG-JEN [TW]; SU JUH-YUH [TW]) 5 February 2009 (2009-02-05) and EP 1 635 383 A2 (SHARP KK [JP]) 15 March 2006 (2006-03-15) are further pieces of prior art relevant to the instant disclosure.

Accordingly, there remains a need to develop methods that preserve the integrity of growth substrates for reuse.

In particular, there remains a need to be able to transfer the active regions of III-V solar cells from the original wafers to host substrates via epitaxial lift-off that further enables reuse of wafers multiple times and allows for fabrication of flexible high-efficiency thin-film solar cells. Re-polishing the wafers consumes tens of micrometers of material from the top surface of the wafer. Thus, to allow for reuse of the wafer while avoiding loss of the material through re-polishing, protective layers are used to protect the wafer surface from dilute HF during the epitaxial lift off ("ELO") process.

The present disclosure addresses the need to further develop more efficient, light weight, and flexible PV devices. The present disclosure also addresses the need to develop methods of non-destructively removing epitaxial growth layers from a growth substrate, and preserving the integrity of the growth substrate for reuse without the requirement of polishing or other destructive methods of preparing its surface prior to its next use.

There are disclosed advanced protection layer concepts comprising the use of an at least three -layer protection scheme comprising protective layers made, for example, of slowly etched III-V material such as InAlP, AlGaAs, and InAlGaP. As used herein, the term "III-V material," may be used to refer to compound crystals containing elements from group IIIA and group VA of the periodic table. More specifically, the term III-V material may be used herein to refer to compounds which are combinations of the group of Gallium (Ga), Indium (In) and Aluminum (Al), and the group of Arsenic (As), Phosphorous (P), Nitrogen (N), and Antimony (Sb).

It should be noted that the compounds herein are named in an abbreviated format. A two component material is considered to be in approximately a 1:1 molar ratio of group III:V compounds. In a three or more component system (e.g. InGaAlAsP), the sum of the group III species (i.e. In, Ga, and Al) is approximately 1 and the sum of the group V components (i.e. As, and P) is approximately 1, and thus the ratio of group III to group V is approximately unity.

Names of compounds (e.g. GaAs, AlInP, GaInP, AlGaAs, GaPSb, AlPSb and combinations thereof for lattice compounds lattice matched to GaAs, or InP, InGaAs, AlInP, GaInP, InAs, InSb, GaP, AlP, GaSb, AlSb and combinations thereof and for compounds lattice matched to InP) are assumed to be in the stoichiometric ratio needed to achieve lattice matching or strain, as inferred from the surrounding text. For example, to lattice match InGaP to InP, the composition is $In_{0.53}Ga_{0.47}As$. AlGaAs (i.e. $Al_xGa_{1-x}As$) is an interesting example because it is nearly lattice matched to GaAs across the entire composition range of $0 \leq X \leq 1$. Additionally, names can be transposed to some degree. For example, AlGaAs and GaAlAs are the same material.

In a further embodiment, there is disclosed a method of preserving the integrity of a growth substrate, comprising:

providing a structure having a growth substrate with at least one growing surface; a cell; a sacrificial layer; and at least three protective layers;
releasing the cell by etching the sacrificial layer with an etchant;
removing the third protective layer by etching the third protective layer with an etchant;
removing the second protective layer by etching the second protective layer with an etchant; and
removing the first protective layer by etching the first protective layer with an etchant.

In this embodiment, the first protective layer is positioned above the growth substrate, the second protective layer is positioned above the first protective layer, the third protective layer is positioned above the second protective layer, and the sacrificial layer is positioned above the third protective layer.

The protective layers may comprise lattice matched compounds and/or strained layers. Regardless of whether the first protective layer is lattice matched or strained, a high etch selectivity between the first protective layer and the growth substrate is highly preferred such that the first protective layer can be removed with a wet etchant that stops abruptly on the growth substrate.

As used herein the term etchant selectivity refers to the rate at which a particular etchant removes a particular material when compared to the rate of etching of another material. Etchant selectivity of X and Y is quantified as the ratio between the etching rate of X to the etching rate of Y for a particular etchant. Accordingly, "highly selective," as used herein, refers to instances where one material is etched rapidly while the other is etched very slowly or not etched at all, such as greater than 10:1, or 100:1, or even 1000:1, or greater.

In one embodiment, each etchant is independently selected from HF, $H_3PO_4$, HCl, $H_2SO_4$, $HNO_3$, $C_6H_8O_7$ (citric acid), $H_2O_2$, $H_2O$ and combinations thereof.

In another embodiment, there is disclosed a growth structure according to claim 11.

In one embodiment, the substrate may comprise GaAs, and the substrate protective layers and device structure protective layers may be lattice matched compounds, such as GaAs, AlInP, GaInP, AlGaAs, GaPSb, AlPSb and combinations thereof.

In another embodiment, the substrate may comprise GaAs and the substrate protective layers and device structure protective layers may be strained layers, such as InP, InGaAs, InAlAs, AlInP, GaInP, InAs, InSb, GaP, AlP, GaSb, AlSb and combinations thereof, including combinations with lattice matched compounds.

In another embodiment, the substrate may comprise InP and the substrate protective layers and device structure protective layers may be lattice matched compounds such as InGaAs, InAlAs, GaAsSb, AlAsSb, and combinations thereof.

In another embodiment, the substrate may comprise InP and the substrate protective layers and device structure protective layers may be strained layers, such as InGaAs, InAlAs, GaAsSb, AlAsSb, InAs, GaSb, AlSb, GaAs, GaP and AlP, and combinations thereof, including combinations with lattice matched compounds.

In yet another embodiment, the growth substrate and the second substrate protective layer may comprise the same material.

In one embodiment, the GaAs substrate is protected by a layer scheme comprising GaAs-Substrate/InAlP/In-GaP/GaAs/InAlP/AlAs.

The foregoing and other features of the present disclosure will be more readily apparent from the following detailed description of exemplary embodiments, taken in conjunction with the attached drawings. It will be noted that for convenience all illustrations of devices show the height dimension exaggerated in relation to the width.

**Figure 1**. is an example of a layer structure showing, from bottom to top, the substrate wafer, substrate (sub) protection layer 1 through n, the epitaxial lift off (ELO) release layer, the device protection layers m through 1, the device, and finally any desired protection layers on top of the device layers.

**Figure 2**. is a three-dimensional surface profiling image of the surface of (a) fresh GaAs wafer and (b) AlInP, (c) GaInP, (d) GaAs surface after epitaxial lift-off (ELO) simulation.

**Figure 3**. shows atomic force micrographs of the surface of (a) fresh GaAs wafer and (b) GaInP, (c) AlInP, (d) GaAs surface after epitaxial lift-off (ELO) simulation and (e) GaAs surface after protection layer removal. Root-mean-square (RMS) roughness values for the surfaces are (a) 0.209 nm, (b) 0.673 nm, (c) 4.71 nm, (d) 3.09 nm, and (e) 0.563 nm.

**Figure 4.** shows IV plots of devices grown on a new wafer and a reused wafer.

**Figure 5.** is an example layer structure showing a bi-layer protection system.

**Figure 6(a).** is a three-dimensional surface profiling image of the GaAs surface after epitaxial lift-off (ELO) using the structure of Figure 5.

**Figures 6(b)** shows the surface roughness after removal of the protection removal depicted in Figure 5, **and Figure 6(c)** shows the comparable surface roughness of a fresh wafer

As used herein, the term "layer" refers to a member or component of a photosensitive device whose primary dimension is X-Y, i.e., along its length and width, and is typically perpendicular to the plane of incidence of the illumination. It should be understood that the term "layer" is not necessarily limited to single layers or sheets of materials. A layer can comprise laminates or combinations of several sheets of materials. In addition, it should be understood that the surfaces of certain layers, including the interface(s) of such layers with other material(s) or layers(s), may be imperfect, wherein said surfaces represent an interpenetrating, entangled or convoluted network with other material(s) or layer(s). Similarly, it should also be understood that a layer may be discontinuous, such that the continuity of said layer along the X-Y dimension may be disturbed or otherwise interrupted by other layer(s) or material(s).

Previously, a bi-layer protection scheme using lattice matched etch stop layer and protection layer comprised of the same material as the wafer (i.e. InP-wafer/InGaAs/InP) has been disclosed. Applicants have previously described this scheme in U.S. Patent Application No. 12/878,261. The present disclosure is directed to variations on the protection layers with various material combinations that can protect the parent wafer during the ELO process, and enable the preparation of regrowth interface.

As used herein, the terms "wafer" and "growth substrate" can be used interchangeably to mean the same thing.

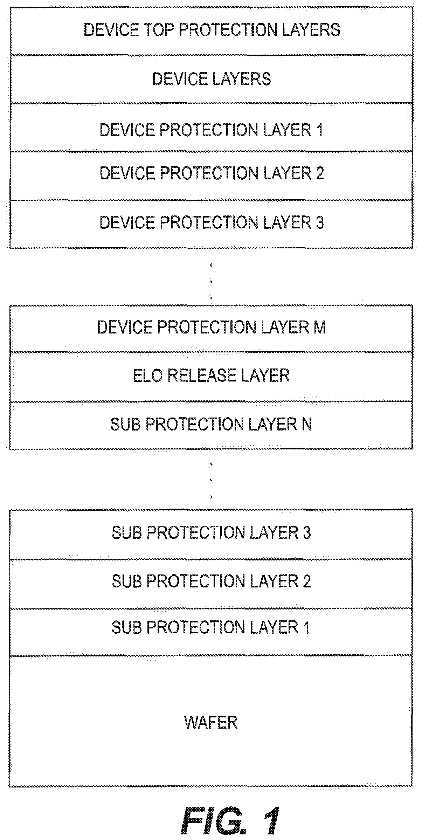

While the descriptions below only describe the layers used to protect the substrate ("Sub layer"), similar layers may be necessary to protect the device structure (both surfaces) as well. In the latter, the device structure protective layers are grown in the inverse order described herein and as seen in Fig. 1.

The protective layers may comprise lattice matched compounds and/or strained layers, such as under the strain-relaxation critical thickness for strained layers. In certain embodiments, at least one of the protective layers is lattice matched, in other embodiments, at least two of the protective layers are lattice matched, and in further embodiments, at least three of the protective layers are lattice matched. In additional embodiments, at least one of the protective layers is strained, in other embodiments, at least two of the protective layers are strained, and in further embodiments, at least three of the protective layers are strained. It is also contemplated that the protective layers can comprise a combination of at least one layer that is lattice matched and at least one layer that is strained.

The single layer protection scheme and the double layer protection scheme described in the following do not fall under the claimed invention and are disclosed for illustrative purposes only.

A single-layer protection scheme can be used to protect the surface of the wafer from dilute HF during the ELO process. To prepare the regrowth interface, a high etch selectivity between wafer material and protection layer material is highly preferred. An example of this single layer structure can be envisioned in Figure 1, by assuming that only one protection layer is used (Sub protection layer 1 with 2-n omitted). The substrate protection layer 1 is intended to have a high selectivity with the ELO etchant so that it can be removed with a wet etchant that stops on the wafer surface, leaving a clean, smooth surface.

In certain embodiments, the thickness of the etch stop layer in a single-layer protection scheme can be increased to allow for removal of surface contaminates. In certain embodiments, the surface contaminates can be removed prior to etching of the etch stop layer such as HCl: $H_3PO_4$:$H_2O$ (1:1:1) which has very to selectivity to InGaP over GaAs.

Alternatively, a double-layer protection scheme can be used. In Figure 1, this would include Sub protection layers 1 and 2. For this type of protection layer structure, the primary purpose of the layer 2 is to provide an etch stop against the ELO etch, and will be removed with an appropriate wet etch that does not need to stop perfectly (e.g. low selectivity or no selectivity in etchants are acceptable for this embodiment) on Sub protection layer 1. Sub protection layer 1 should be removed with an etchant that stops cleanly and smoothly on the substrate. A second aspect of Sub protection layer 1 is that it helps lift debris off of the surface that may remain after the attempted removal of Sub protection layer 2. It should be noted that the same material as the wafer can be employed as the Sub protection layer 2.

While lifting off InP layers in the past, it was found that the InP surface could be exposed to the HF etchant for over a week without degradation; however, GaAs exposed to HF for as short as two days can develop a residue or surface contamination and become impossible to clean, rendering wafer reuse impossible.

Thus, in accord with the present invention, at least a triple-layer protection scheme can be employed. In Fig. 1, this would include Sub protection layers 1, 2, and 3-n. The primary purpose of each layer follows that described in the previous paragraph, except sub protection layer 3 is positioned against the ELO release layer, and so forth.

The reason for adding additional layers is to add more options for creating a smooth surface after wet etching the various layers away and to allow more options for choosing the material that is grown below the AlAs ELO release layer, allowing separately for the use of the best available etchant-material combinations for protection during liftoff and creating a smooth surface for re-growth. More specifically, since the selectivity between AlAs and other III-V compounds materials to HF is not infinite and the protection layer may react with HF, creating residues/damage that are very difficult to completely remove, additional protection layers can be added to separately assist in removal of any residues, allow for best etch chemistries, and place the optimal material adjacent to the AlAs lift off layer, providing the best surface fidelity.

For epitaxial lift-off (ELO) from GaAs wafers, virtually any III-V compound can be used as a protective layer as long as appropriate layer thicknesses are used, including lattice matched AlInP, GaInP, AlGaAs, GaPSb, AlPSb and combinations thereof, and strained InP, InGaAs, AlInP, GaInP, InAs, InSb, GaP, AlP, GaSb, AlSb and combinations thereof (including combinations with lattice matched layers) can be used as a protective layers. For lift off from InP substrates, lattice matched compounds of InGaAs, InAlAs, GaAsSb, AlAsSb, and combinations thereof, and strained layers of InGaAs, InAlAs, GaAsSb, AlAsSb, InAs, GaSb, AlSb, GaAs, GaP and AlP, and combinations thereof (including combinations with lattice matched layers) can be used as protective layers. It should be noted that the growth substrate and at least one of the protective layers may comprise the same material. It should also be noted that dilute alloys, such as those containing nitrogen or bismuth, can also be used and layers can be grown with or without dopants.

In some embodiments more than three protective layers may be used and protective layer materials may be repeated, as shown, for example, by GaAs wafer/InGaP/GaAs/InGaP/InAlAs.

While the present disclosure discusses wet etching, dry etches such as plasma etches, including reactive ion etching (RIE), could be used to remove layers without etch selectivity needed for wet-etch options. Dry etches are often a combination of a non reactive gas such as argon to provide a physical etching mechanism and a reactive compound such as chlorine to help remove species from the surface.

Arsenic oxide buildup can slow the AlAs etch during lift-off. By cladding the AlAs with a slowly etched III-V material (e.g. InAlP, AlGaAs, InAlGaP) the arsenic oxide buildup can be reduced; thus, expediting the lift-off process. For example, InGaP was used for the protection layer (in an InGaP/GaAs/InGaP trilayer protection scheme) next to the AlAs ELO sacrificial layer and performance was improved over that of a bilayer with GaAs adjacent to the AlAs.

In one embodiment, a thin layer of strained InP may be placed against the AlAs ELO layer to improve the robustness of the ELO process further. The layer of InP could be thinner than the strain relaxation thickness (~1.7 nm) or it may be thicker, such as 10 nm of strained AlAs on InP (the same strain value, but opposite sign as for this situation) for liftoff without noticeable degradation to device layers above.

InAlP may be used in a multi-layer protection scheme on a GaAs substrate. InAlP is advantageous because it can be etched with dilute HCl, which stops abruptly on GaAs and the etch selectivity is ~$10^6$:1, whereas the etchant for InGaP (HCl:$H_3PO_4$) slowly etches GaAs and may cause roughening of the surface. According to this embodiment, the layer structure comprises GaAs Substrate/InAlP/other protection layers, such as GaAs-substrate/InAlP/InGaP/GaAs/In-AlP/AlAs, where the InAlP is slowly etched during the lift-off process, and further removed with dilute HCL. Then the GaAs is removed with $H_3PO_4$:$H_2O_2$:$H_2O$, which stops on InGaP. The InGaP is removed with HCL: $H_3PO_4$ (note: may be diluted with $H_2O$), and the InAlP is removed with dilute HCl.

InGaP is useful as a protection layer because it is a very good etch-stop layer for GaAs etching and vice versa.

One embodiment of this layer structure comprises GaAs-substrate/InGaP/GaAs/InGaP. InGaP can be etched using full strength HCl: $H_3PO_4$ (1:1) for 1.5 minutes. GaAs can be etched using $H_3PO_4$:$H_2O_2$:$H_2O$ (3:1:25) for 1 minute. Both etches are carried out for longer than necessary (i.e. "over-etched") to ensure that the top layers are completely removed. Because of the high selectivity, lower layers are undamaged. Removing the final layer (InGaP) is an important step. In one embodiment, full strength HCl: $H_3PO_4$ (1:1), which slowly damages the surface of the GaAs substrate, is substituted with dilute HCl: $H_3PO_4$:$H_2O$ (1:1:1), which does not damage or etch the surface after 2.5 minutes. There are no significant changes in surface roughness after 2.5 min ~ 6.5 min etching using dilute etchant. After the complete protection layer removal, the surface roughness is ~0.5nm; however, an even smoother surface can be obtained after optimization with dilute HCl etching of a final layer of InAlP as described above.

In another embodiment, the protection layer scheme may be improved by removing GaAs from the layer stack. The growth surface often contains intrinsic defects from the growth process as well as extrinsic particulate contamination. Because the wafer could be damaged from exposure to GaAs etchant leaking through pinholes in the layers, or through easily etched defect structures, it may be advantageous to completely remove GaAs from the protection layer stack. One example of at least a triple-layer protection scheme comprises: GaAs wafer/InAlP/InGaP/InAlP. Eliminating GaAs from the protection layer scheme may help to prevent etching of the GaAs growth surface through defects and sidewall etching.

In some embodiments, the removal of the protective layers may be accomplished by using an etchant such as HF. Other suitable etchants may include phosphoric acid ($H_3PO_4$), hydrochloric acid (HCl), sulfuric acid ($H_2SO_4$), hydrogen peroxide ($H_2O_2$), nitric acid ($HNO_3$), citric acid ($C_6H_8O_7$), and combinations thereof. For example, suitable etchant combinations may include $H_3PO_4$:HCl, $H_2SO_4$:$H_2O_2$:$H_2O$, and HF:$H_2O_2$:$H_2O$.

The invention will be further clarified by the following non-limiting examples, which are intended to be purely exemplary of the invention.

## Example 1

In this example, the inventive ELO process using a triple-layer protection scheme with lattice matched InGaP, GaAs, AlInP as protective layers on GaAs, was demonstrated by exposing the surface to 7.5% dilute HF for two days.

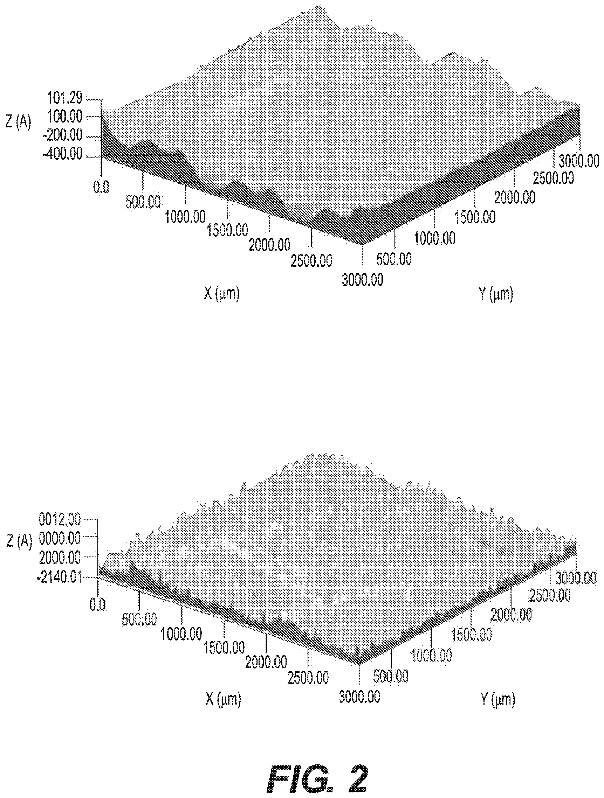

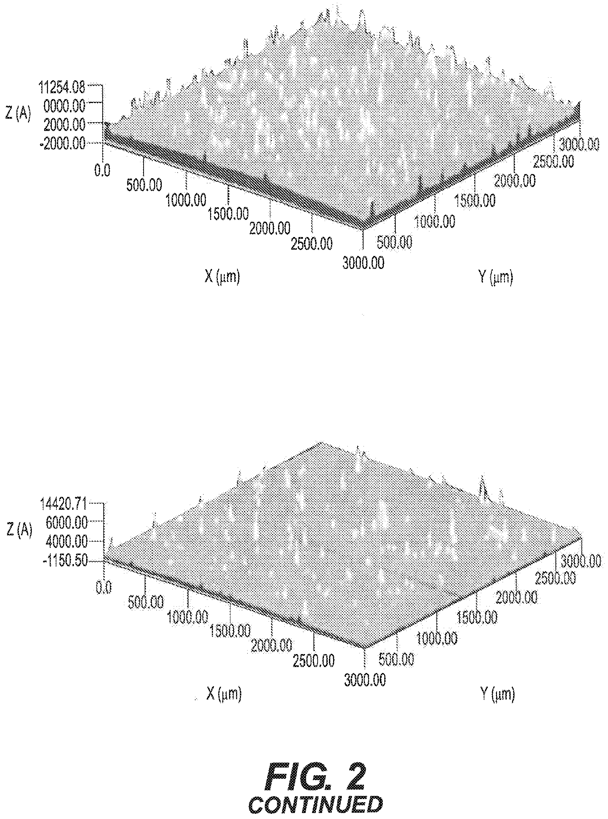

Figure 2 shows the surface morphology after the ELO simulation. According to the surface morphology, the protection layer surface also slowly reacted with HF. Therefore, the growth after the ELO without reclaim or protection of surface was almost impossible.

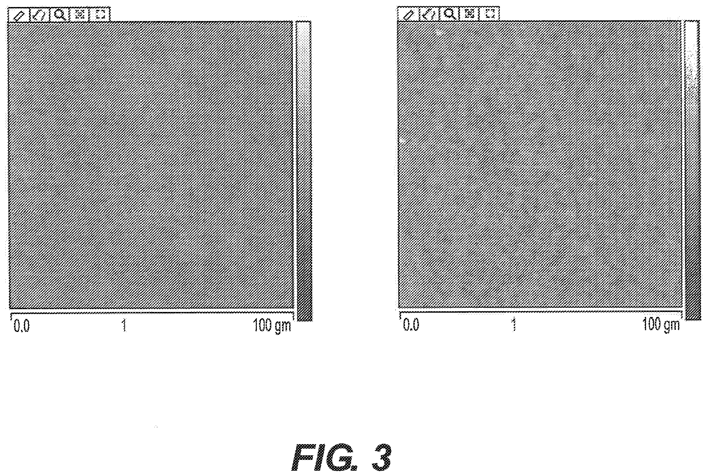

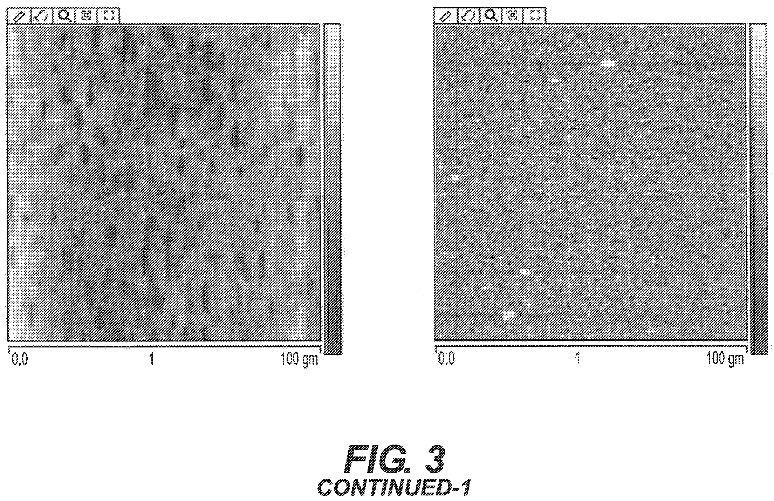

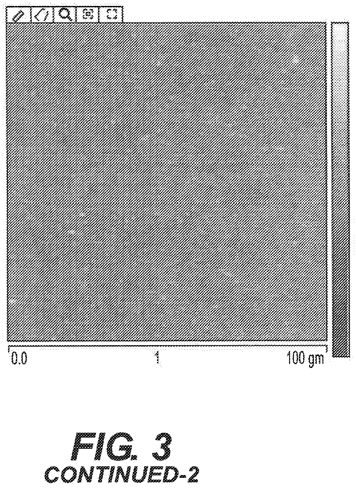

Figure 3 shows the atomic force microscope (AFM) images of the protection layer after ELO simulation and after protection layer removal, and it confirmed that the protection layer protected the wafer, and enabled the regrowth.

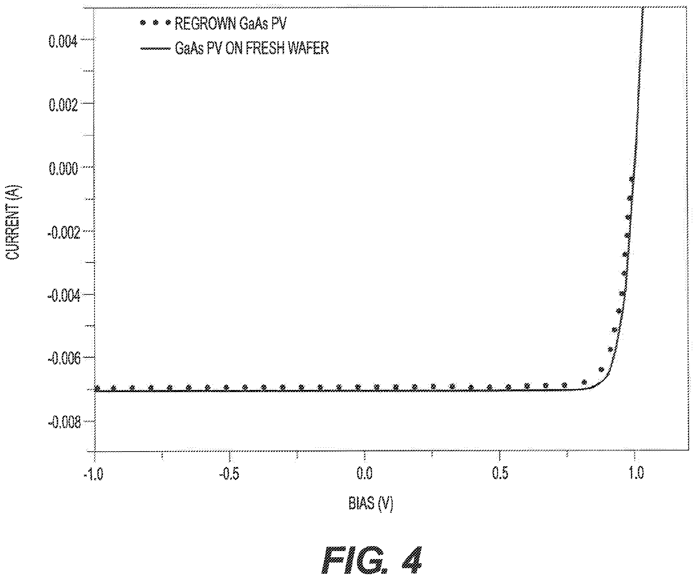

To prove the concept of wafer reuse, performance of regrown and fabricated GaAs solar cell after protective layers (lattice matched InGaP/GaAs/InGaP) were removed was compared with that of GaAs solar cell grown on fresh GaAs wafer. Figure 4 shows IV curves for devices grown on a fresh wafer and for the wafer that was reused once after a simulated ELO process.

**Table 1.**

|  | $I_{SC}$ | $V_{OC}$ | FF | Eta |
|---|---|---|---|---|
| **Control GaAs cell** | 28.2 mA/cm$^2$ | 1.01V | 84.4% | 23.9% |
| **Regrown GaAs cell** | 27.7 mA/cm$^2$ | 1.01V | 81.6% | 22.8% |

Table 1 shows the extracted parameters for the solar cells: a. Short circuit current ($I_{SC}$), b. open circuit voltage ($V_{OC}$), c. fill factor (FF) and d. power conversion efficiency shows that almost no degradation in the photovoltaic performance. The discrepancy of device performance is thought to be due to variations in the fabrication process between runs.

## Example 2

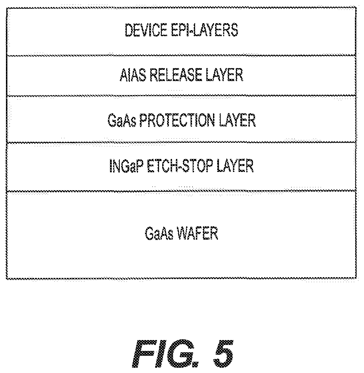

In this example, which is not part of the claimed invention and disclosed for illustrative purposes only, the effectiveness of a bi-layer protection system was tested. The protection scheme comprised an etch stop layer (0.1um thick InGaP) and a protection layer (0.1um thick GaAs) to protect the parent GaAs wafer surface during the ELO process as depicted in Fig. 5.

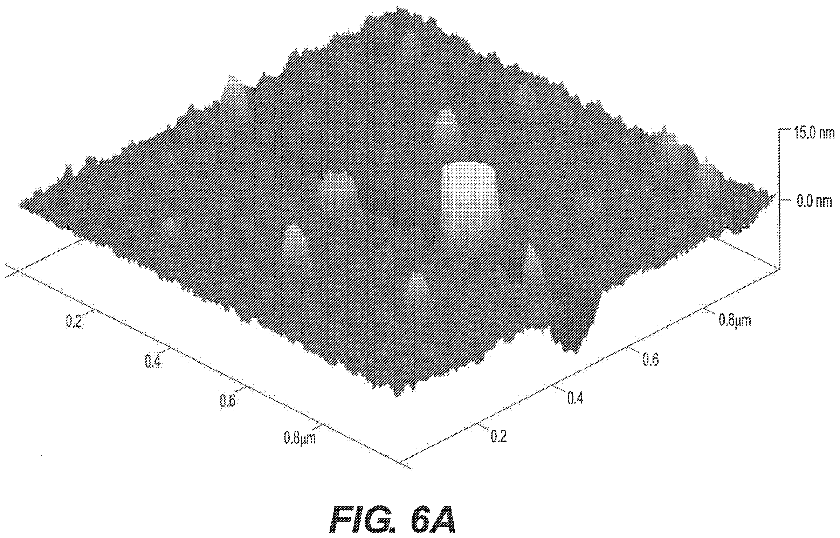

As seen in Fig.6(a), the ELO process can develop a residue or surface contamination that is difficult to etch away cleanly. The contaminates can be removed by increasing the thickness of the GaAs protection or InGaAp etch stop layer layer to allow for undercutting of the contaminates or by using a cleaning process to remove these contaminates.

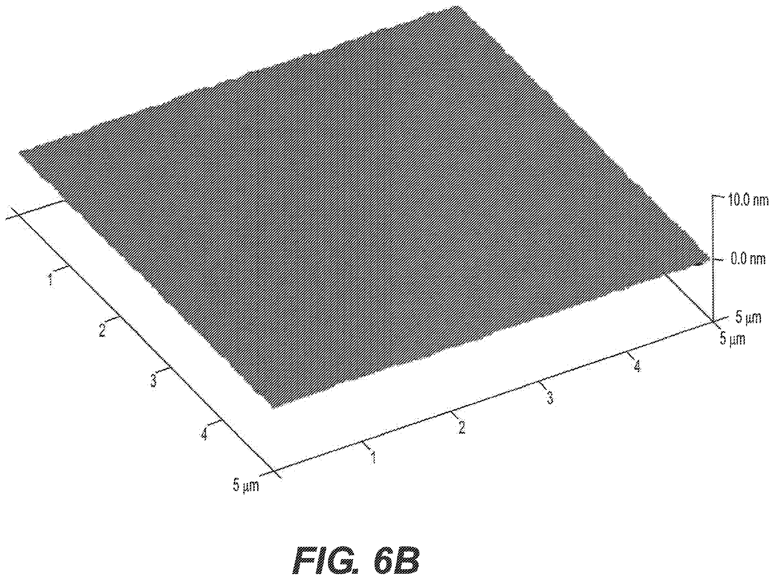

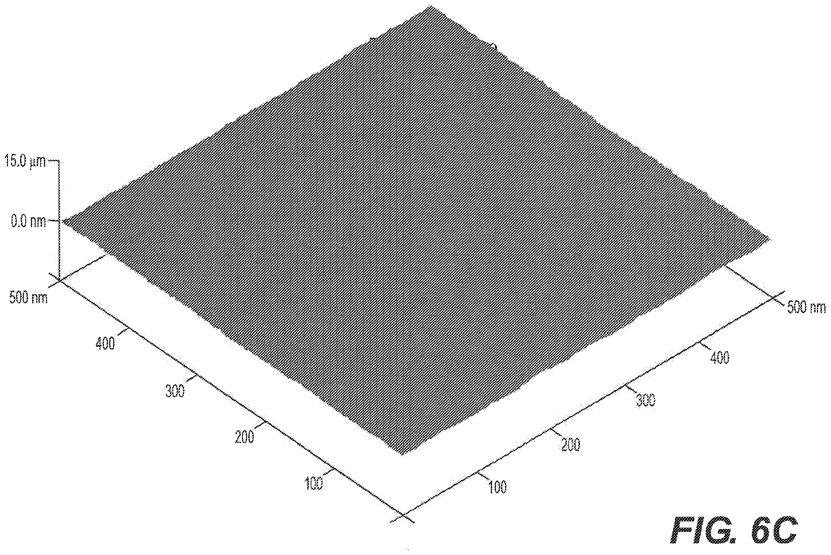

In this example, after the pre-cleaning the surface, the protection layer and etch-stop layer were removed by wet etching using $H_3PO_4$:$H_2O_2$:$H_2O$ (3:1:25) and $H_3PO_4$:HCl (1:1), respectively. The surface roughness after protection removal (root mean square(RMS) roughness of 0.2 nm) (Fig. 6 (b)) was comparable with that of fresh wafer (RMS roughness of 0.2 nm) (Fig. 6 (c)).

Other than in the examples, or where otherwise indicated, all numbers expressing quantities of ingredients, reaction conditions, analytical measurements, and so forth used in the specification and claims are to be understood as being modified in all instances by the term "about." Accordingly, unless indicated to the contrary, the numerical parameters set forth in the specification and attached claims are approximations that may vary depending upon the desired properties sought to be obtained by the present disclosure. At the very least, and not as an attempt to limit the application of the doctrine of equivalents to the scope of the claims, each numerical parameter should be construed in light of the number of significant digits and ordinary rounding approaches.

Notwithstanding that the numerical ranges and parameters setting forth the broad scope of the disclosure are approximations, unless otherwise indicated the numerical values set forth in the specific examples are reported as precisely as possible. Any numerical value, however, inherently contains certain errors necessarily resulting from the standard deviation found in their respective testing measurements.

**Claims**

1. A method of preserving the integrity of a growth substrate, comprising:

   providing a structure having a growth substrate with at least one growing surface; a cell; a sacrificial layer; and at least three protective layers, wherein the first protective layer is positioned above the growth substrate, the second protective layer is positioned above the first protective layer, the third protective layer is positioned above the second protective layer, and the sacrificial layer is positioned between the third protective layer and the at least one cell;
   releasing the cell by etching the sacrificial layer with an etchant;
   removing the third protective layer by etching the third protective layer with an etchant;
   removing the second protective layer by etching the second protective layer with an etchant; and
   removing the first protective layer by etching the first protective layer with an etchant.

2. The method of claim 1 wherein at least one of the protective layers is comprised of lattice matched compounds.

3. The method of claim 1, wherein at least one of the protective layers is a strained layer.

4. The method of claim 1, wherein the first protective layer has a high selectivity with the etchant, wherein said high selectivity is 10:1 or greater.

5. The method of claim 2, wherein the growth substrate is GaAs and at least one of the at least three protective layers is selected from lattice matched AlInP, GaInP, AlGaAs, GaPSb, AlPSb, and combinations thereof, preferably wherein the at least three protective layers are selected from lattice matched AlInP, GaInP, AlGaAs, GaPSb, AlPSb, and combinations thereof.

6. The method of claim 3, wherein the growth substrate is GaAs and at least one of the at least three protective layers is selected from strained InP, InGaAs, AlInP, GaInP, InAs, InSb, GaP, AlP, GaSb, AlSb, and combinations thereof, including combinations with lattice-matched compounds, preferably wherein the at least three protective layers are selected from strained InP, InGaAs, AlInP, GaInP, InAs, InSb, GaP, AlP, GaSb, AlSb, and combinations thereof.

7. The method of claim 2, wherein the substrate is InP and at least one of the at least three protective layers is selected from lattice matched InGaAs, InAlAs, GaAsSb, AlAsSb, and combinations thereof.

8. The method of claim 3, wherein the substrate is InP and at least one of the at least three protective layers is selected from strained InGaAs, InAlAs, GaAsSb, AlAsSb, InAs, GaSb, AlSb, GaAs, GaP and AlP, and combinations thereof, including combinations with lattice-matched compounds.

9. The method of claim 1, wherein the growth substrate and one of the protective layers comprise the same material, or wherein none of the protective layers comprise the same material as the growth substrate.

**10.** The method of claim 1, wherein the substrate comprises GaAs and wherein the protective layer scheme comprises GaAs-Substrate/InAlP/InGaP/GaAs/InAlP/AlAs.

**11.** A growth structure comprising a growth substrate, a sacrificial layer, a buffer layer, at least first, second, and third substrate protective layers, at least one epilayer, at least one contact, and a metal coated host substrate, wherein the first substrate protective layer is positioned above the growth substrate, the second substrate protective layer is positioned above the first substrate protective layer, the third substrate protective layer is positioned above the second substrate protective layer, and the sacrificial layer is positioned between the third substrate protective layer and the at least one epilayer.

**12.** The growth structure of claim 11, wherein the at least first, second, and third substrate protective layers are lattice matched compounds, preferably wherein the growth substrate comprises GaAs and the at least first, second, and third substrate protective layers are selected from lattice matched AlInP, GaInP, AlGaAs, GaPSb, AlPSb and combinations thereof; or preferably wherein the substrate comprises InP and the at least first, second, and third substrate protective layers are selected from lattice matched InP, InGaAs, InAlAs, GaAsSb, AlAsSb, and combinations thereof.

**13.** The growth structure of claim 11, wherein the at least first, second, and third substrate protective layers are strained layers, preferably wherein the growth substrate comprises GaAs and the at least first, second, and third substrate protective layers are selected from strained InP, InGaAs, AlInP, GaInP, InAs, InSb, GaP, AlP, GaSb, AlSb and combinations thereof, including combinations with lattice-matched compounds; or preferably wherein the substrate comprises InP and the at least first, second, and third substrate protective layers are selected from strained InGaAs, InAlAs, GaAsSb, AlAsSb, InAs, GaSb, AlSb, GaAs, GaP and AlP, and combinations thereof, including combinations with lattice-matched compounds.

## Patentansprüche

**1.** Verfahren zum Wahren der Integrität eines Wachstumssubstrats, umfassend:

Bereitstellen einer Struktur mit einem Wachstumssubstrat mit mindestens einer wachsenden Oberfläche; einer Zelle; einer Opferschicht und mindestens drei Schutzschichten, wobei die erste Schutzschicht über dem Wachstumssubstrat positioniert ist, die zweite Schutzschicht über der ersten Schutzschicht positioniert ist, die dritte Schutzschicht über der zweiten Schutzschicht positioniert ist und die Opferschicht zwischen der dritten Schutzschicht und der mindestens einen Zelle positioniert ist;
Freigeben der Zelle durch Ätzen der Opferschicht mit einem Ätzmittel;
Entfernen der dritten Schutzschicht durch Ätzen der dritten Schutzschicht mit einem Ätzmittel;
Entfernen der zweiten Schutzschicht durch Ätzen der zweiten Schutzschicht mit einem Ätzmittel;
und Entfernen der ersten Schutzschicht durch Ätzen der ersten Schutzschicht mit einem Ätzmittel.

**2.** Verfahren nach Anspruch 1, wobei mindestens eine der Schutzschichten aus gitterangepassten Verbindungen bestehen.

**3.** Verfahren nach Anspruch 1, wobei mindestens eine der Schutzschichten eine gespannte Schicht ist.

**4.** Verfahren nach Anspruch 1, wobei die erste Schutzschicht eine hohe Selektivität bezüglich des Ätzmittels aufweist, wobei die hohe Selektivität 10:1 oder höher ist.

**5.** Verfahren nach Anspruch 2, wobei das Wachstumssubstrat GaAs ist und mindestens eine der mindestens drei Schutzschichten ausgewählt ist aus gitterangepasstem AlInP, GaInP, AlGaAs, GaPSb, AlPSb und Kombinationen daraus, vorzugsweise
wobei die mindestens drei Schutzschichten ausgewählt sind aus gitterangepasstem AlInP, GaInP, AlGaAs, GaPSb, AlPSb und Kombinationen daraus.

**6.** Verfahren nach Anspruch 3, wobei das Wachstumssubstrat GaAs ist und mindestens eine der mindestens drei Schutzschichten ausgewählt ist aus gespanntem InP, InGaAS, AlInP, GaInP, InAs, InSb, GaP, AlP, GaSb, AlSb Kombinationen daraus, enthaltend Kombinationen mit gitterangepassten Verbindungen, vorzugsweise
wobei die mindestens drei Schutzschichten ausgewählt sind aus gespanntem InP, InGaAs, AlInP, GaInP, InAs, InSb, GaP, AlP, GaSb, AlSb und Kombinationen daraus.

**7.** Verfahren nach Anspruch 2, wobei das Substrat InP ist und mindestens eine der mindestens drei Schutzschichten ausgewählt ist aus gitterangepasstem InGaAs, InAlAs, GaAsSb, AlAsSb und Kombinationen daraus.

**8.** Verfahren nach Anspruch 3, wobei das Substrat InP ist und mindestens eine der mindestens drei Schutzschichten ausgewählt ist aus gespanntem InGaAs, InAlAs, GaAsSb, AlAsSb, InAs, GaSb, AlSb, GaAs, GaP und AlP und Kombinationen daraus, enthaltend Kombinationen mit gitterangepassten Verbindungen.

**9.** Verfahren nach Anspruch 1, wobei das Wachstumssubstrat und eine der Schutzschichten dasselbe Material umfassen, oder
wobei keine der Schutzschichten dasselbe Material umfasst wie das Wachstumssubstrat.

**10.** Verfahren nach Anspruch 1, wobei das Substrat GaAs umfasst und wobei der Schutzschichtaufbau GaAs-Substrat/InAlP/InGaP/GaAs/InAlP/AlAs umfasst.

**11.** Wachstumsstruktur, umfassend ein Wachstumssubstrat, eine Opferschicht, eine Pufferschicht, mindestens eine erste, zweite und dritte Substratschutzschicht, mindestens eine Epitaxialschicht, mindestens einen Kontakt und ein metallbeschichtetes Host-Substrat, wobei die erste Substratschutzschicht über dem Wachstumssubstrat positioniert ist, die zweite Substratschutzschicht über der ersten Substratschutzschicht positioniert ist, die dritte Substratschutzschicht über der zweiten Substratschutzschicht positioniert ist und die Opferschicht zwischen der dritten Substratschutzschicht und der mindestens einen Epitaxialschicht positioniert ist.

**12.** Wachstumsstruktur nach Anspruch 11, wobei die mindestens erste, zweite und dritte Substratschutzschicht gitterangepasste Verbindungen sind, vorzugsweise wobei das Wachstumssubstrat GaAs umfasst und die mindestens erste, zweite und dritte Substratschutzschicht ausgewählt sind aus gitterangepasstem AlInP, GaInP, AlGaAs, GaPSb, AlPSb und Kombinationen daraus; oder vorzugsweise wobei das Substrat InP umfasst und die mindestens erste, zweite und dritte Substratschutzschicht ausgewählt sind aus gitterangepasstem InP, InGaAs, InAlAs, GaAsSb, AlAsSb und Kombinationen daraus.

**13.** Wachstumsstruktur nach Anspruch 11, wobei die mindestens erste, zweite und dritte Substratschutzschicht gespannte Schichten sind, vorzugsweise wobei das Wachstumssubstrat GaAs umfasst und die mindestens erste, zweite und dritte Substratschutzschicht ausgewählt sind aus gespanntem InP, InGaAs, AlInP, GaInP, InAs, InSb, GaP, AlP, GaSb, AlSb und Kombinationen daraus, enthaltend Verbindungen mit gitterangepassten Verbindungen; oder vorzugsweise wobei das Substrat InP umfasst und die mindestens erste, zweite und dritte Substratschutzschicht ausgewählt sind aus gespanntem InGaAs, InAlAs, GaAsSb, AlAsSb, InAs, GaSb, AlSb, GaAs, GaP und AlP und Kombinationen daraus, enthaltend Kombinationen mit gitterangepassten Verbindungen.

**Revendications**

**1.** Méthode de maintien de l'intégrité d'une substrat de croissance, comprenant :

la constitution d'une structure possédant un substrat de croissance avec au moins une surface de croissance ;
une cellule ;
une couche sacrificielle ; et
au moins trois couches de protection, la première couche de protection étant positionnée au-dessus du substrat de croissance, la deuxième couche de protection étant positionnée au-dessus de la première couche de protection, la troisième couche de protection étant positionnée au-dessus de la deuxième couche de protection, et la couche sacrificielle étant positionnée entre la troisième couche de protection et l'au moins une cellule ;
la libération de la cellule par gravure de la couche sacrificielle avec un agent de gravure ;
l'enlèvement de la troisième couche de protection par la gravure de la troisième couche de protection avec un agent de gravure ;
l'enlèvement de la deuxième couche de protection par la gravure de la deuxième couche de protection avec un agent de gravure ; et l'enlèvement de la première couche de protection par la gravure de la première couche de protection avec un agent de gravure.

**2.** Méthode selon la revendication 1, au moins une des couches de protection étant constituée de composés adaptés en réseau.

3. Méthode selon la revendication 1, au moins une des couches de protection étant une couche contrainte.

4. Méthode selon la revendication 1, la première couche de protection présentant une sélectivité élevée avec l'agent de gravure, ladite sélectivité élevée étant égale à 10/1 ou supérieure.

5. Méthode selon la revendication 2, le substrat de croissance étant GaAs, et au moins une des au moins trois couches de protection étant sélectionnée parmi les suivantes : AlInP, GaInP, AlGaAs, GaPSb, AlPSb adaptées en réseau, et des combinaisons de ces dernières, de préférence les au moins trois couches de protection étant sélectionnées parmi les suivantes : AlInP, GaInP, AlGaAs, GaPSb, AlPSb adaptées en réseau, et des combinaisons de ces dernières.

6. Méthode selon la revendication 3, le substrat de croissance étant GaAs, et au moins une des au moins trois couches de protection étant sélectionnée parmi les suivantes : InP, InGaAs, AlInP, GaInP, InAs, InSb, GaP, AIP, GaSb, AlSb contraintes, et des combinaisons de ces dernières, y compris des combinaisons avec des composés adaptés en réseau, de préférence les au moins trois couches de protection étant sélectionnées parmi les suivantes : InP, InGaAs, AlInP, GaInP, InAs, InSb, GaP, AIP, GaSb, AlSb contraintes, et des combinaisons de ces dernières.

7. Méthode selon la revendication 2, le substrat étant InP, et au moins une des au moins trois couches de protection étant sélectionnée parmi les suivantes : InGaAs, InAlAs, GaAsSb, AlAsSb adaptées en réseau, et des combinaisons de ces dernières.

8. Méthode selon la revendication 3, le substrat étant InP, et au moins une des au moins trois couches de protection étant sélectionnée parmi les suivantes : InGaAs, InAlAs, GaAsSb, AlAsSb, InAs, GaSb, AlSb, GaAs, GaP et AIP contraintes, y compris des combinaisons avec des composés adaptés en réseau.

9. Méthode selon la revendication 1, le substrat de croissance et une des couches de protection comprenant le même matériau, ou
aucune des couches de protection comprenant le même matériau que le substrat de croissance.

10. Méthode selon la revendication 1, le substrat comprenant GaAs, et le système de couche de protection comprenant GaAs-Substrat/InAlP/InGaP/GaAs/InAlP/AlAs.

11. Structure de croissance comprenant un substrat de croissance, une couche sacrificielle, une couche tampon, au moins des première, deuxième, et troisième couches de protection du substrat, au moins une couche épitaxiale, au moins un contact, et un substrat hôte à revêtement métallique, la première couche de protection du substrat étant positionnée au-dessus du substrat de croissance, la deuxième couche de protection du substrat étant positionnée au-dessus de la première couche de protection du substrat, la troisième couche de protection du substrat étant positionnée au-dessus de la deuxième couche de protection du substrat, et la couche sacrificielle étant positionnée entre la troisième couche de protection du substrat et l'au moins une couche épitaxiale.

12. Structure de croissance selon la revendication 11, les au moins première, deuxième, et troisième couches de protection étant des composés adaptés en réseau, de préférence le substrat de croissance comprenant GaAs et les au moins première, deuxième, et troisième couches de protection du substrat étant sélectionnées parmi les suivantes : AlInP, GaInP, AlGaAs, GaPSb, AlPSb adaptées en réseau, et des combinaisons de ces dernières, ou, de préférence, le substrat comprenant InP, et les au moins première, deuxième, et troisième couches de protection du substrat étant sélectionnées parmi les suivantes : InP, InGaAs, InAlAs, GaAsSb, AlAsSb adaptées en réseau, et des combinaisons de ces dernières.

13. Structure de croissance selon la revendication 11, les au moins première, deuxième, et troisième couches de protection du substrat étant des couches contraintes, de préférence le substrat de croissance comprenant GaAs et les au moins première, deuxième, et troisième couches de protection du substrat étant sélectionnées parmi les suivantes : InP, InGaAs, AlInP, GaInP, InAs, InSb, GaP, AIP, GaSb, AlSb contraintes, et des combinaisons de ces dernières, y compris des combinaisons avec des composés adaptés en réseau ; ou, de préférence, le substrat comprenant InP, et les au moins première, deuxième, et troisième couches de protection du substrat étant sélectionnées parmi des InGaAs, InAlAs, GaAsSb, AlAsSb, InAs, GaSb, AlSb, GaAs, GaP et AIP contraintes, et des combinaisons de ces dernières, y compris des combinaisons avec des composés adaptés en réseau.

| DEVICE TOP PROTECTION LAYERS |
|---|
| DEVICE LAYERS |
| DEVICE PROTECTION LAYER 1 |
| DEVICE PROTECTION LAYER 2 |
| DEVICE PROTECTION LAYER 3 |

.
.
.

| DEVICE PROTECTION LAYER M |
|---|
| ELO RELEASE LAYER |
| SUB PROTECTION LAYER N |

.
.
.

| SUB PROTECTION LAYER 3 |
|---|
| SUB PROTECTION LAYER 2 |
| SUB PROTECTION LAYER 1 |
| WAFER |

## FIG. 1

**FIG. 2**

**FIG. 2**
**CONTINUED**

FIG. 3

**FIG. 3**
**CONTINUED-1**

**FIG. 3**
**CONTINUED-2**

**FIG. 4**

EP 2 727 140 B1

| DEVICE EPI-LAYERS |
| AlAS RELEASE LAYER |
| GaAs PROTECTION LAYER |
| INGaP ETCH-STOP LAYER |
| GaAs WAFER |

*FIG. 5*

*FIG. 6A*

**FIG. 6B**

*FIG. 6C*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20100047959 A
- DE 102008034801 A1
- EP 1635383 A2
- US 878261 A